# FASCICULE DE BREVET EUROPEEN

(11) **EP 1 295 297 B1**
(45) Date de publication et mention de la délivrance du brevet: **12.10.2005**
(21) Numéro de dépôt: 01947509.4
(22) Date de dépôt: 18.06.2001
(51) Int. Cl.: G11C 16/22, G06F 1/00

(54) **CIRCUIT DE DETECTION D'UTILISATION**
VERWENDUNGSERKENNUNGSSCHALTUNG
USE DETECTING CIRCUIT

(30) Priorité: 19.06.2000 FR 0007762
(43) Date de publication de la demande: 26.03.2003
(73) Titulaire: STMicroelectronics S.A., 92120 Montrouge (FR)
(72) Inventeur: LIARDET, Pierre-Yvan, F-13760 Peynier (FR); MUSSARD, Bruno, F-13170 Les Pennes Mirabeau (FR)
(74) Mandataire: Bentz, Jean-Paul
(86) Numéro de dépôt international: PCT/FR2001/001891
(87) Numéro de publication internationale: WO 2001/099113

(56) Documents cités:
- EP-A- 0 707 270
- WO-A-99/27539
- FR-A- 2 712 412
- US-A- 5 210 716
- "INCREASE OF A NON-VOLATILE RAM LIFETIME" IBM TECHNICAL DISCLOSURE BULLETIN, IBM CORP. NEW YORK, US, vol. 30, no. 10, 1 mars 1988 (1988-03-01), page 382 XP000111851 ISSN: 0018-8689
- PATENT ABSTRACTS OF JAPAN vol. 012, no. 048 (P-666), 13 février 1988 (1988-02-13) & JP 62 194592 A (MITSUBISHI ELECTRIC CORP), 27 août 1987 (1987-08-27)
- PATENT ABSTRACTS OF JAPAN vol. 007, no. 042 (P-177), 19 février 1983 (1983-02-19) & JP 57 191893 A (HITACHI SEISAKUSHO KK), 25 novembre 1982 (1982-11-25)

## Description

L'invention a pour objet un circuit de détection d'utilisation pour un élément de circuit intégré produisant ou utilisant une donnée sensible en terme de sécurité. Plus précisément, l'invention vise à signaler l'utilisation abusive d'un élément d'un circuit intégré produisant ou utilisant une donnée sensible. L'invention est notamment intéressante pour les circuits intégrés pour cartes à puce qui produisent ou utilisent des données que l'on souhaite garder secrètes, mais elle peut également être utilisée pour tout élément de circuit intégré utilisant des données sensibles que l'on souhaite pouvoir protéger vis-à-vis de l'extérieur du circuit.

Les données sensibles sont par exemple des données personnelles identifiant le propriétaire ou le fabricant du circuit intégré, des clés, initiales ou dérivées, d'algorithme de cryptage de données, etc. Elles sont produites ou utilisées par des éléments du circuit intégré.

L'expression "élément" de circuit intégré doit être comprise ici, et dans tout ce qui suit, au sens large. Un élément désigne par exemple un circuit d'identification ou bien un circuit de calcul cryptographique du circuit intégré ou même simplement une partie de l'un de ces circuits. Un élément désigne également une instruction, une suite particulière d'instructions ou une étape d'un procédé mise en oeuvre par le circuit intégré et qui, lors de son exécution, entraîne la production ou l'utilisation d'une donnée sensible.

Des techniques d'espionnage connues tirent partie de la corrélation entre la production ou l'utilisation d'une donnée sensible et l'évolution d'une grandeur physique inhérente au circuit intégré et mesurable depuis l'extérieur du circuit. Une telle grandeur est par exemple la consommation d'énergie globale du circuit ou bien son rayonnement électromagnétique.

Pour accéder à une donnée sensible depuis l'extérieur du circuit, un utilisateur espion déclenche la mise en service d'un élément produisant ou utilisant la donnée sensible, mesure une grandeur physique accessible depuis l'extérieur et cherche la corrélation entre cette grandeur et la donnée sensible.

Une des principales difficultés pour l'utilisateur espion réside dans le fait que la mesure de la grandeur est particulièrement difficile car elle est généralement bruitée, la grandeur physique étant produite par l'ensemble du circuit intégré et non par les seuls éléments produisant ou manipulant la donnée sensible. L'utilisateur espion doit alors disposer d'un nombre important de mesures identiques, par exemple de l'ordre de 2 000 à 20 000, pour éliminer le bruit de la mesure et réussir sa démarche.

Pour empêcher de telles agressions, l'utilisateur légitime peut agir préventivement, si un élément produisant ou utilisant la donnée sensible est sollicité trop souvent; il peut par exemple inhiber le fonctionnement de l'élément, c'est-à-dire inhiber le fonctionnement du circuit, de la partie du circuit, de l'instruction ou de la série particulière d'instructions, qui produit ou utilise la donnée sensible. L'utilisateur légitime peut également agir préventivement en remplaçant la ou les données sensibles par d'autres données si il est prévu des données de substitution, ou bien en modifiant le mécanisme de production de cette ou ces données.

Pour cela, l'utilisateur légitime doit pouvoir connaître le nombre d'utilisations de l'élément produisant ou utilisant la donnée sensible, ou du moins une estimation de ce nombre, pour savoir si l'élément est utilisé de manière abusive ou pas. Il peut considérer que c'est le cas lorsque le nombre d'utilisations ou l'estimation de ce nombre a atteint une valeur N choisie, par exemple 1 000 ou 10 000; il peut alors agir préventivement en bloquant le fonctionnement du circuit intégré, en empêchant la production ou l'utilisation de la donnée sensible à protéger, ou bien encore en modifiant la valeur de cette donnée sensible.

Des solutions existent, qui utilisent généralement un compteur pour déterminer le nombre de productions ou d'utilisations de l'élément utilisant la donnée sensible. Cependant, un inconvénient de l'utilisation d'un compteur est qu'il est nécessaire de disposer d'une cellule mémoire de taille importante si on souhaite mémoriser le nombre produit par le compteur lorsque ce nombre est grand. La surface et la consommation du compteur lui-même, ainsi que le temps nécessaire pour programmer le compteur, peuvent également ne pas être négligeables, notamment si le nombre produit par ce compteur est grand. De plus, si le compteur dispose de moyens de réinitialisation, ces moyens sont en général assez facilement accessibles depuis l'extérieur du circuit par un utilisateur espion, qui peut alors aisément effacer le contenu du compteur.

Au vu des inconvénients des solutions actuelles, un but de l'invention est de réaliser un circuit de détection d'utilisation qui fournit une indication du nombre d'utilisations d'un élément produisant ou utilisant une donnée sensible et qui signale, le cas échéant, le dépassement d'un nombre maximum d'utilisations, ce nombre maximum étant défini par l'utilisateur.

Un autre but de l'invention est de réaliser un circuit de détection de taille réduite, en terme de surface de silicium.

Un autre but de l'invention est également de réaliser un circuit de détection qui soit rapide.

Un autre but de l'invention enfin est de réaliser un circuit de détection d'usure qui conserve une mémoire du passé de l'élément auquel il est relié et qui ne peut être effacé ou remis à zéro de manière simple.

Avec ces objectifs en vue, l'invention a pour objet un circuit de détection d'utilisation d'un élément sensible d'un circuit intégré, qui comprend :
- un circuit de mémorisation non volatil électriquement programmable et
- un circuit de programmation pour programmer partiellement ledit circuit de mémorisation et modifier progressivement son niveau de programmation au fur et à mesure des utilisations de l'élément sensible, de sorte que ce niveau soit représentatif du nombre d'utilisations de l'élément sensible. Le circuit de l'invention fournit ainsi l'indication recherchée.

Rappelons qu'ici, et dans ce qui suit, un élément peut être un circuit ou une partie d'un circuit qui produit ou utilise une donnée sensible à protéger. Un élément peut également être une instruction ou une série d'instructions particulière qui, lorsqu'elle est exécutée, peut produire ou utiliser la donnée sensible.

Le niveau de programmation du circuit de mémorisation est ainsi représentatif, au moins approximativement, du nombre de programmations partielles réalisées, et donc du nombre d'utilisations de l'élément du circuit intégré. Le nombre maximum d'utilisations autorisées est par exemple défini par l'utilisateur. Connaissant le taux d'utilisation de l'élément, l'utilisateur peut alors agir préventivement si nécessaire, par exemple en bloquant le fonctionnement de l'élément du circuit intégré, en modifiant la valeur de la donnée sensible, ou en modifiant le mécanisme de production de la donnée sensible.

Selon un mode préféré de réalisation, le circuit est complété par un circuit de mesure, pour mesurer le niveau de programmation du circuit de mémorisation et produire un signal d'alerte si ce niveau atteint un niveau de référence représentatif d'un nombre maximum d'utilisations autorisées de l'élément sensible. L'utilisateur est ainsi directement informé par le signal d'alerte du dépassement du nombre d'utilisations autorisées.

Selon le mode de réalisation de l'invention choisi, le circuit de détection d'utilisation peut éventuellement être moins précis qu'un compteur, comme on le verra mieux par la suite. Cependant, dans tous les cas, le circuit de détection de l'invention donne une estimation correcte du nombre d'utilisations du ou des éléments, par exemple à 5 ou 10% près, et cette estimation est suffisante pour permettre à l'utilisateur d'intervenir préventivement.

Selon un mode de réalisation de l'invention, le circuit de mémorisation comprend au moins une cellule de mémorisation programmable par des étapes de programmation partielle. La cellule de mémorisation peut être par exemple de type EEPROM, EPROM ou de type FLASH.

Le circuit de détection d'utilisation de l'invention est ainsi plus sûr qu'un circuit comprenant un compteur car, contrairement à un compteur, le circuit de l'invention ne peut être réinitialisé de manière simple. En effet, le contenu d'une cellule de mémorisation ne peut pas être effacé de manière simple. Le circuit détection de l'invention conserve donc dans le temps une trace de l'utilisation de l'élément du circuit intégré auquel il est relié.

De plus, le circuit de détection de l'invention est beaucoup plus petit que les circuits habituellement utilisés et comprenant un compteur, car une cellule de mémorisation est de taille beaucoup plus réduite.

Le circuit de détection selon l'invention est avantageusement complété par un circuit de sortie, pour mémoriser le signal d'alerte produit par le circuit de mesure. L'utilisateur peut ainsi savoir à tout instant si un signal d'alerte a été émis par le circuit de mesure, simplement en vérifiant le contenu du circuit de sortie.

Selon un mode de réalisation du circuit de mémorisation, il comprend plusieurs cellules de mémorisation utilisées de manière successive au fur et à mesure de l'utilisation de l'élément. Une cellule de mémorisation est utilisée lorsqu'une cellule de mémorisation précédente a atteint un niveau maximum, de sorte que le niveau de programmation de la dernière cellule de mémorisation programmées ajouté au niveau maximum de la ou des cellules précédentes déjà programmées soit représentatif du nombre d'utilisations de l'élément.

Selon un autre mode de réalisation du circuit de mémorisation, il comprend plusieurs cellules de mémorisation, chaque cellule de mémorisation étant utilisée pour mémoriser le nombre d'utilisations d'un élément sensible du circuit intégré associé à ladite cellule de mémorisation, de sorte que le niveau de programmation de chaque cellule de mémorisation soit représentatif du nombre d'utilisations de l'élément sensible qui lui est associé.

Le circuit de détection selon l'invention est encore avantageusement complété par des moyens d'inhibition, pour inhiber le fonctionnement du circuit de programmation, ce qui permet de limiter la consommation énergétique du circuit de détection d'utilisation.

L'invention a également pour objet un procédé de détection d'utilisation d'un élément sensible d'un circuit intégré, caractérisé en ce qu'il comprend une étape de programmation partielle d'un circuit de mémorisation non volatil électriquement programmable, effectuée lorsque l'élément sensible est utilisé, de sorte à modifier progressivement le niveau de programmation du circuit de mémorisation au fur et à mesure des utilisations de l'élément sensible.

Ainsi, chaque fois que l'élément du circuit intégré est utilisé, une programmation partielle, et de préférence lente, du circuit de mémorisation est effectuée par le circuit de programmation. De cette façon, quelques charges électriques supplémentaires s'accumulent dans le circuit de mémorisation et son niveau de programmation augmente à chaque programmation, c'est-à-dire à chaque utilisation de l'élément du circuit intégré.

Selon un mode de réalisation du procédé de l'invention, les étapes de programmation partielle réalisées sont identiques à chaque utilisation de l'élément sensible. Par étapes identiques, il faut comprendre ici des étapes ayant des paramètres identiques, comme par exemple une durée ou une quantité d'énergie fournie au circuit de mémorisation. Dans ce cas, le niveau de programmation du circuit de mémorisation est directement proportionnel au nombre d'utilisations de l'élément; il donne donc une indication assez précise du nombre d'utilisations réelles de l'élément.

Selon un autre mode de réalisation, des paramètres d'une étape de programmation partielle varient au fur et à mesure des utilisations de l'élément sensible. Il est possible par exemple de faire varier la durée d'une étape ou la quantité d'énergie fournie au cours d'une étape de programmation en fonction du nombre d'utilisations déjà réalisées, pour donner plus d'importance aux premières ou aux dernières utilisations de l'élément.

Dans certains cas, il est souhaitable protéger un circuit intégré comprenant au moins deux éléments sensibles; ou bien un circuit intégré comprenant un élément sensible utilisant ou produisant au moins deux données sensibles. On choisira de préférence pour cela un circuit de mémorisation comprenant une ou plusieurs cellules de mémorisation.

Dans le cas de l'utilisation de plusieurs cellules de mémorisation, il est possible d'associer une cellule de mémorisation à l'utilisation d'un unique élément sensible. Il est également possible d'associer une cellule de mémorisation à l'utilisation d'un unique élément sensible produisant ou utilisant une unique donnée sensible.

Dans le cas de l'utilisation d'un circuit de mémorisation comprenant une unique cellule de mémorisation, des étapes de programmation partielle sont effectuées à chaque utilisation de l'un des éléments sensibles (ou à chaque utilisation de l'un des éléments sensibles associée à une même donnée sensible), les paramètres d'une étape de programmation pouvant être variables en fonction de l'élément sensible utilisé et /ou de la donnée sensible utilisée par ledit élément sensible.

Ceci est notamment intéressant si l'élément sensible produit ou utilise des données sensibles ayant des importances différentes, ou des données plus ou moins facilement décelables depuis l'extérieur. Dans le même esprit, le procédé peut être utilisé dans le cas d'un circuit intégré comprenant un ou plusieurs éléments sensibles, chaque élément sensible produisant ou utilisant une ou plusieurs données sensibles

Quel que soit le mode de réalisation choisi, le niveau de programmation du ou des circuits de mémorisation augmente, éventuellement plus ou moins vite, en fonction de la production ou de l'utilisation de la ou des données sensibles par le ou les éléments sensibles du circuit intégré. Le niveau de programmation de l'un ou de l'autre des circuits de mémorisation est représentatif, au moins approximativement, du nombre d'étapes de programmation partielle réalisées, et donc du nombre d'utilisations du ou des éléments du circuit intégré.

Avantageusement, le procédé selon l'invention est complété par une étape de mesure, pour mesurer le niveau de programmation du circuit de mémorisation et produire un signal d'alerte si ledit niveau atteint une valeur représentative d'un nombre maximum d'utilisations autorisées de l'élément sensible.

Selon des modes de réalisation du procédé, l'étape de mesure est réalisée après chaque réalisation d'une étape de programmation partielle, après la réalisation d'un nombre M d'étapes de programmation, sur demande d'utilisateur extérieur ou même de manière aléatoire.

Avantageusement, le procédé est encore complété par une étape de mémorisation du signal d'alerte. Une trace du signal d'alerte peut ainsi être conservée.

L'invention sera mieux comprise et d'autres caractéristiques et avantages apparaîtront à la lecture de la description qui va suivre d'un exemple de réalisation d'un circuit de détection d'usure, selon l'invention, la description faisant référence aux dessins annexés dans lesquels :
- la figure 1 est un schéma fonctionnel d'un circuit de détection d'utilisation, selon l'invention,
- la figure 2 présente un exemple de réalisation d'un circuit selon l'invention,
- les figures 3 à 5 sont des schémas électroniques illustrant certains éléments de la figure 2,
- les figures 6a à 6j sont des diagrammes des signaux à différents points des schémas des figures 3 à 5, et
- la figure 7 est un schéma d'une amélioration possible du circuit de la figure 2.

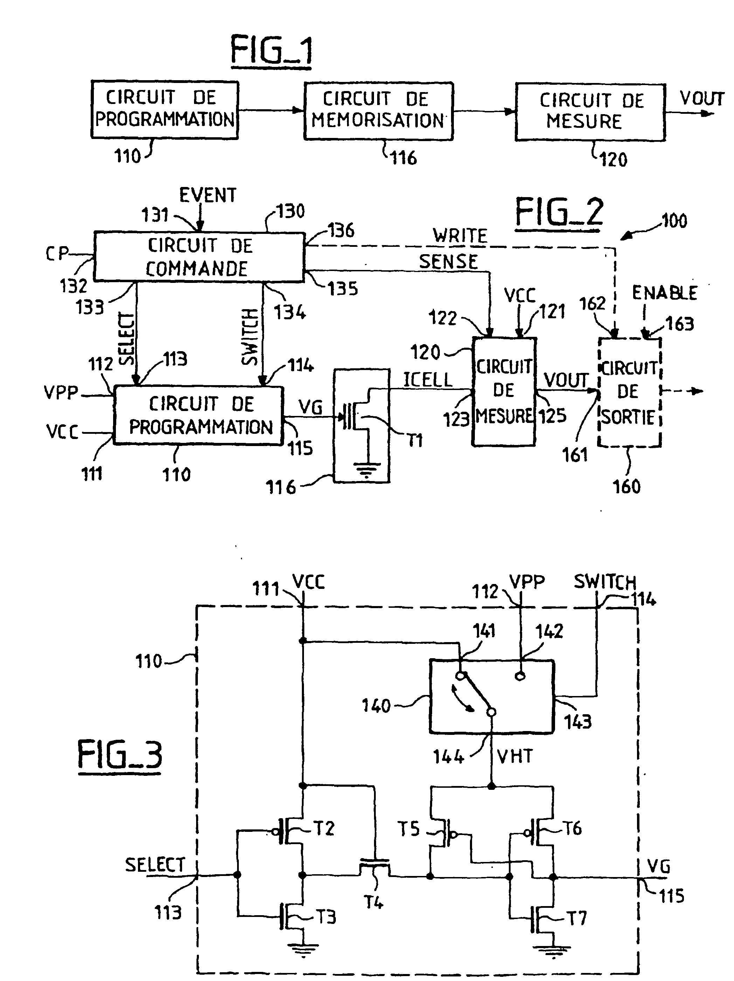

Le circuit 100 de détection d'utilisation de la figure 1 comprend un circuit 110 de programmation, un circuit 116 de mémorisation, électriquement programmable et non volatil et formé d'une ou plusieurs cellules de mémorisation, et un circuit 120 de mesure. Le circuit 100 est installé dans un circuit intégré dont on souhaite protéger un ou des éléments sensibles contre une utilisation abusive. Son principe général de fonctionnement a été expliqué précédemment, et peut être résumé ici brièvement ici.

A chaque utilisation d'un élément sensible associé au circuit de détection d'utilisation, le circuit 100 réalise une programmation partielle du circuit 116 de mémorisation, de sorte que le niveau de programmation du circuit 116 est représentatif du nombre d'utilisations de l'élément sensible déjà réalisées.

Le circuit 120 mesure le niveau de programmation du circuit 116 et produit un signal VOUT d'alerte si ce niveau dépasse un niveau de référence représentatif d'un nombre maximum d'utilisations autorisées de l'élément sensible. Le circuit 120 peut être activé par exemple après chaque programmation du circuit 116, toutes les M (nombre entier, par exemple égal à 10) programmations du circuit 116 ou bien de manière aléatoire.

Comme on l'a vu précédemment, la mesure du niveau de programmation peut être effectuée après chaque programmation partielle, après un nombre M de programmations partielle, sur demande d'un utilisateur ou bien de manière aléatoire.

La figure 2 présente un exemple de réalisation d'un circuit 100 de détection d'utilisation, utilisé pour réaliser, à chaque utilisation d'un élément une programmation partielle du circuit de mémorisation, qui est identique à chaque utilisation de l'élément, puis une lecture du circuit de mémorisation.

Le circuit 100 de détection d'utilisation de la figure 2 comprend , un circuit 110 de programmation, un circuit 116 de mémorisation, un circuit 120 de mesure et un circuit 130 de commande.

Le circuit 110 de programmation comprend deux bornes 111, 112 d'entrée d'alimentation sur lesquelles sont appliqués respectivement un potentiel VCC d'alimentation et un potentiel VPP de programmation, et deux bornes 113, 114 d'entrée de sélection sur lesquelles sont appliqués respectivement un signal SELECT d'inhibition et un signal SWITCH de programmation. Le circuit 110 fournit, sur une borne 115 de sortie, un potentiel VG de commande qui prend trois valeurs en fonction des signaux SELECT et SWITCH :
VG = VPP si SELECT = 1 et SWITCH = 1,
VG = VCC si SELECT = 1 et SWITCH = 0, et
VG = 0V si SELECT = 0.

Le circuit 116 est réalisé dans l'exemple de la figure 2 par une unique cellule de mémorisation de type EEPROM formée d'un transistor de mémorisation T1, de type à grille flottante; T1 comprend une grille connectée à la borne 115 de sortie du circuit 110, une source connectée à une masse du circuit et un drain.

Le circuit 120 de mesure comprend une borne 121 d'entrée d'alimentation sur laquelle est appliquée le potentiel VCC, une borne 122 d'entrée de commande sur laquelle est appliqué un signal SENSE de mesure, et une borne 123 d'entrée connectée au drain du transistor T1.

Lorsqu'il reçoit le signal SENSE, le circuit 120 compare un courant ICELL circulant dans le canal du transistor de mémorisation T1 avec un courant de référence IREF et il fournit, sur une borne 125 de sortie, un signal VOUT d'alerte dont l'état est représentatif de la valeur du courant ICELL comparativement à celle du courant de référence IREF.

Le circuit 130 de commande comprend une borne 131 d'entrée sur laquelle est appliqué un signal EVENT d'indication d'utilisation, une borne 132 d'entrée sur laquelle est appliqué un signal CP d'horloge, deux bornes 133, 134 de sortie connectées respectivement aux bornes 113, 114 du circuit 110 et une borne 135 de sortie. Le circuit 130 fournit, respectivement sur les bornes 133, 134, 135, les signaux de commande SELECT, SWITCH, SENSE en fonction du signal EVENT.

Dans l'exemple illustré figure 2, on considère que le signal EVENT est fourni sous la forme d'une impulsion par un élément (unité arithmétique et logique, circuit de multiplication, circuit de cryptage, etc.) du circuit intégré. Plus généralement, le signal EVENT peut être fourni par un élément (ou une partie d'un élément) qui produit ou utilise directement une donnée sensible, ou bien par un circuit de commande qui pilote l'élément produisant ou utilisant la donnée sensible. Il peut aussi être fourni par un élément lorsqu'il exécute une instruction particulière ou une série particulière d'instructions mettant éventuellement en oeuvre la donnée à protéger.

Le fonctionnement complet du circuit de détection d'utilisation de la figure 2 est le suivant.

Lorsque le circuit 130 reçoit une impulsion EVENT indiquant que l'élément dont on souhaite détecter l'utilisation est utilisé, il fournit alors des signaux SELECT, SENSE égaux respectivement à 1 et à 0 et un potentiel VG égal à VPP est appliqué sur la grille du transistor T1. Une programmation partielle du transistor T1 est effectuée et son niveau de programmation augmente en conséquence.

Le circuit 130 fournit ensuite des signaux SELECT, SENSE égaux tous deux à 1. Le circuit 120 effectue alors une mesure du niveau de programmation du transistor de mémorisation T1 en mesurant le courant ICELL circulant dans le canal du transistor T1. Si ICELL est inférieur ou égal au courant de référence IREF, alors le signal VOUT est égal à 1. Inversement, si ICELL est supérieur à IREF, alors le signal VOUT est égal à 0 (Rappelons que le courant circulant dans une cellule de mémorisation de type EEPROM est inversement proportionnel à son niveau de programmation).

Le circuit 110 de programmation comprend, conformément au schéma de la figure 3, six transistors T2 à T7 et un interrupteur 140 commandé.

L'interrupteur 140 comprend deux bornes 141, 142 et une borne 143 d'entrée de commande connectées respectivement aux bornes 111, 112 et 114 du circuit 110. L'interrupteur 140 fournit, sur une borne 144 de sortie, un potentiel VHT qui a les caractéristiques suivantes :
VHT = VPP si SWITCH = 1, et
VHT = VCC si SWITCH = 0.

Le transistor T2 est de type P; sa source est connectée à la borne 111 du circuit 110 et son drain est connecté au drain du transistor T3 de type N, dont la source est reliée à la masse du circuit. Les grilles de commande des transistors T2, T3 sont connectées ensemble à la borne 113 pour recevoir le signal SELECT. Les transistors T2, T3 forment un inverseur logique, ils fournissent sur leur drain un signal inverse du signal SELECT.

Le transistor T4 est de type N, son drain et sa grille sont connectés respectivement au drain et à la source du transistor T2. Le transistor T5 est un transistor de type P dont le drain et la source sont connectés respectivement à la source du transistor T4 et à la borne 144 de l'interrupteur 140.

Le transistor T6 est de type P; sa source est connectée à la borne 144 de l'interrupteur 140 et son drain est connecté au drain du transistor T7 de type N, dont la source est reliée à la masse du circuit. Les drains des transistors T6, T7 sont connectés ensemble à la grille du transistor T5 et à la borne de sortie 115, et leurs grilles de commande sont connectées ensemble au drain du transistor T4. Les transistors T6, T7 forment un inverseur haute tension. Ils fournissent sur leur drain un potentiel VG qui est égal au potentiel VHT si un potentiel nul est appliqué sur leur grille de commande, et ils fournissent un potentiel VG nul sur leur drain si un potentiel égal au potentiel VCC est appliqué sur leur grille.

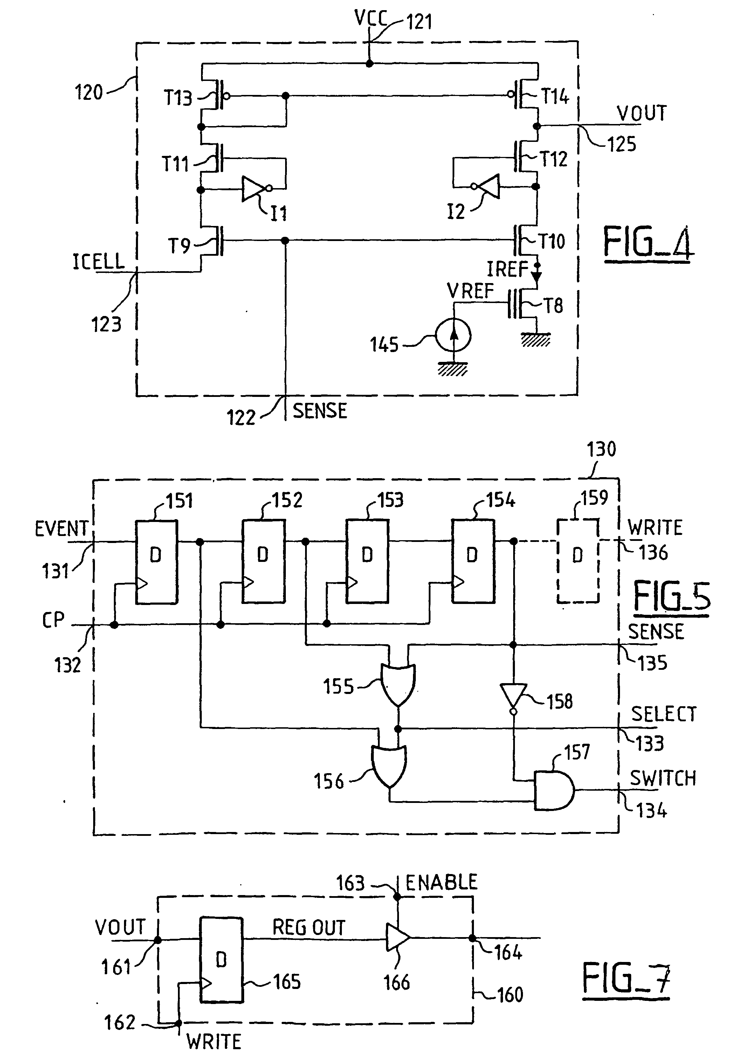

Le circuit 120 de mesure comprend, conformément au schéma de la figure 4, sept transistors T8 à T14, deux inverseurs I1, I2 et une source 145 de potentiel de polarisation.

Dans l'exemple illustré, on considère un transistor T8 de taille identique à celle du transistor T1, dont la source est connectée à la masse du circuit et dont la grille de commande est connectée à la borne positive de la source 145 dont la borne négative est connectée à la masse. La source 145 fournit un potentiel VREF de polarisation donné sur la grille du transistor de mémorisation T8; un courant IREF de polarisation donné circule alors entre le drain et la source de T8.

Dans l'exemple illustré, on a choisi un transistor T8 de taille identique à celle du transistor T1. Le potentiel VREF de la source 145 de polarisation est choisi de telle sorte que, lorsque le potentiel VREF est appliqué sur la grille du transistor T8, le courant IREF circulant dans le drain de T8 est égal au courant traversant un transistor identique à T8 qui a subi environ N étapes de programmation partielle avec un potentiel égal à VPP sur sa grille.

D'autres choix sont possibles : on pourra par exemple prendre T1 de taille N fois la taille de T8. Ceci permet de comparer directement les courants, en tenant compte du facteur d'échelle, sans avoir à utiliser un transistor T8 de taille importante. En effet, si on veut pouvoir comptabiliser un grand nombre d'utilisations sur le transistor T1, on devra utiliser un transistor T1 avec une grille flottante de taille plus importante pour ne pas être rapidement au niveau maximum de programmation du transistor. Dans ce cas, on choisira un potentiel VREF tel que, lorsqu'il est appliqué sur la grille de T8, le courant IREF circulant dans le drain de T8 est égal au courant traversant un transistor identique à T8 qui a subi une seule étape de programmation partielle.

Il est encore possible d'utiliser plusieurs cellules de mémorisation successivement.

Plus généralement, le choix du transistor T1 d'une cellule de mémorisation, du transistor T8 du circuit 120 et de la source 145 est fonction notamment de :
- du nombre maximum d'utilisations autorisées,
- de paramètres de réalisation de la programmation partielle : durée, quantité de charges fournies, etc.,
- de paramètres de réalisation de programmations partielles différentes selon l'élément de circuit utilisé, dans le cas où l'activité de plusieurs éléments est détectée avec un même circuit de détection 100,
- du nombre de cellules de mémorisation utilisées,
- etc.

Les transistors T9, T10 sont des transistors de type N dont les grilles de commande sont connectées ensemble à la borne 122 du circuit 120. La source du transistor T9 et connectée à la borne 123 et celle du transistor T10 est connectée au drain du transistor T8. Les transistors T9, T10 inhibent le fonctionnement du circuit 120 lorsque le signal SENSE est inactif

Les transistors T11, T12 sont des transistors de type N. La source du transistor T11 est connectée à sa grille par l'intermédiaire de l'inverseur I1 et au drain du transistor T9. La source du transistor T12 est connectée à sa grille par l'intermédiaire de l'inverseur I2 et au drain du transistor T10. Les transistors T11, T12 ont pour fonction de maintenir constants les potentiels sur les drains des transistors T13, T14, quel que soit la valeur des courants IREF, ICELL.

Les transistors T13, T14, formant un miroir de courant, sont des transistors de type P dont les sources sont connectées ensemble à la borne d'entrée 121 pour recevoir le potentiel VCC et dont les grilles sont connectées ensemble au drain du transistor T13. Le drain du transistor T14 est connecté au drain du transistor T12 et à la borne 125.

Le circuit 130 de commande comprend, dans l'exemple de la figure 4, quatre bascules 151, 152, 153, 154 de type D, trois portes logiques 155, 156, 157 et un inverseur 158.

Les quatre bascules comprennent chacune une borne d'entrée de donnée, une borne d'entrée d'horloge et une borne de sortie de donnée. Les quatre bascules sont associées en série, la borne d'entrée de donnée de la première bascule 151 étant connectée à la borne d'entrée 131 pour recevoir le signal EVENT, et la borne de sortie de la quatrième bascule 154 étant connectée à la borne 135 sur laquelle est fourni le signal SENSE. Les entrées d'horloge des quatre bascules sont connectées ensemble à la borne 132 pour recevoir le même signal d'horloge CP. Chaque bascule est équivalente à un circuit de retard; en effet, chaque bascule transmet sur sa sortie le signal qu'elle a reçu sur son entrée au cycle d'horloge précédent.

La porte logique 155, de type OU, comprend deux bornes d'entrée connectée respectivement à la borne de sortie de la bascule 152 et à la borne de sortie de la bascule 154. La porte 155 fournit le signal SELECT sur une borne de sortie connectée à la borne 133 du circuit 130.

La porte logique 156, de type OU, comprend deux bornes d'entrée connectée respectivement à la borne de sortie de la première bascule 151 et à la borne de sortie de la porte 155.

La porte logique 157, de type ET, comprend deux bornes d'entrée connectées respectivement à la borne de sortie de la bascule 154 par l'intermédiaire de l'inverseur 158 et à une borne de sortie de la porte 156. La porte 157 fournit le signal SWITCH sur une borne de sortie connectée à la borne 134 du circuit 130.

Le fonctionnement global du circuit de la figure 2 va maintenant être décrit en relation avec les figures 7a à 7h qui sont respectivement les chronogrammes des signaux CP, EVENT, SWITCH, SELECT, SENSE et des potentiels VHT, VG et VOUT en différents points du circuit 100 de la figure 2. Le circuit de la figure 2 permet d'indiquer à un utilisateur si un nombre N maximum d'utilisations autorisées d'un élément du circuit intégré est atteint ou pas.

Dans l'exemple, les transistors T1, T8 sont de taille identique, et la source 145 est choisie en conséquence, comme cela a été indiqué précédemment. Dans l'exemple également, toutes les étapes de programmation partielle sont identiques, notamment en terme de potentiels appliqués sur les électrodes du transistor T1 et de temps de programmation.

Initialement, les signaux logiques EVENT, SELECT, SWITCH, SENSE sont égaux à "0", le potentiel VHT sur la borne de sortie de l'interrupteur 140 est égal à VCC et les potentiels VG et VOUT sont nuls.

La première partie des chronogrammes montre l'évolution des signaux lorsqu'une n-ième impulsion EVENT est reçue par le circuit 130, n étant un nombre entier inférieur au nombre maximum N.

Le passage à "1" du signal EVENT à l'instant t0 entraîne le passage à "1" du signal SWITCH un cycle d'horloge CP plus tard à l'instant t1, et le passage à "1" du signal SELECT à l'instant t2.

Lorsque le signal SWITCH passe à "1", l'interrupteur 140 bascule et fournit un potentiel VHT égal à VPP sur sa borne 144. Le signal SELECT étant égal à "0", le circuit 110 fournit un potentiel VG nul.

Lorsque le signal SELECT passe à "1", à l'instant t2, le potentiel VG prend la valeur VPP et il est appliqué sur la grille de commande du transistor T1 dont la source est à un potentiel nul et dont le drain est à un potentiel flottant car le circuit de mesure est inactif (SENSE = "0", les transistors T9, T10 sont bloqués). Quelques charges électriques sont mémorisées dans la grille flottante de T1 pendant un cycle d'horloge et son niveau de programmation augmente légèrement, sans toutefois dépasser une valeur maximale représentative du nombre N.

A l'instant t3, un cycle d'horloge plus tard, Les signaux SELECT et SWITCH passent de "1" à "0", l'interrupteur 140 bascule, le potentiel VHT prend la valeur VCC et le potentiel VG devient nul, la n-ième programmation partielle du transistor T1 est terminée.

A l'instant t4, les signaux SENSE et SELECT passent de "0" à "1". Le potentiel VHT est maintenu égal à VCC car le signal SWITCH est égal à "0". Le signal SELECT étant égal à "1", le potentiel VG prend la valeur VCC et il est appliqué sur la grille du transistor T1 dont la source est à la masse. Le signal SENSE étant égal à "1", les transistors T9, T10 sont passants et un courant ICELL circule entre la source du transistor T9 et celle du transistor T1, le courant ICELL étant représentatif du niveau de programmation du transistor T1, c'est-à-dire du nombre n.

Le circuit 120 compare le courant ICELL au courant IREF circulant dans le transistor T8. Puisque n est inférieur à N, le courant ICELL est supérieur au courant IREF et le signal d'alerte VOUT reste inactif.

A l'instant t5, le signal SELECT passe à "0" et le potentiel VG redevient nul. De plus, le signal SENSE passe à "0", les transistors T9, T10 se bloquent, le courant ICELL disparaît; le signal d'alerte VOUT reste inactif.

En résumé, lorsque la n-ième impulsion EVENT est reçue par le circuit de commande 130 du circuit de détection 100 à l'instant t0, une n-ième étape de programmation partielle du transistor T1 est réalisée entre t2 et t3, une mesure du niveau de programmation de T1 est effectuée entre t4 et t5, puis le niveau de programmation mesuré est finalement comparé à un niveau de référence (associé au nombre N). Le nombre maximum N n'étant pas atteint, le signal d'alerte VOUT reste inactif.

La deuxième partie des chronogrammes montre l'évolution des signaux lorsqu'une m-ième impulsion EVENT est reçue par le circuit 130, m étant un nombre entier supérieur ou égal au nombre N maximum.

Le passage à "1" du signal EVENT à l'instant θ0 entraîne le passage à "1" du signal SWITCH à l'instant θ1, et le passage à "1" du signal SELECT à l'instant θ2. Lorsque le signal SWITCH passe à " 1 ", et le circuit 110 fournit un potentiel VG nul.

Lorsque le signal SELECT passe à "1", à l'instant θ2, le potentiel VG prend la valeur VPP, une m-ième étape de programmation du transistor T1 a lieu, son niveau de programmation augmente légèrement et est supérieur ou égal à la valeur maximale représentative du nombre N.

A l'instant θ3, Les signaux SELECT et SWITCH passent de "1" à "0", le potentiel VHT prend la valeur VCC et le potentiel VG devient nul, la programmation du transistor T1 est terminée.

A l'instant θ4, les signaux SENSE et SELECT passent de "0" à "1". Le potentiel VHT est maintenue égale à VCC car le signal SWITCH est égal à "0". Le signal SELECT étant égal à "1", le potentiel VG prend la valeur VCC. Le signal SENSE étant égal à "1", les transistors T9, T10 sont passants et un courant ICELL circule entre la source du transistor T9 et celle du transistor T1. Le circuit 120 compare le courant ICELL au courant de polarisation circulant dans le transistor T8. Puisque m est supérieur ou égal à N, le courant ICELL est inférieur ou égal au courant IREF et le signal d'alerte VOUT devient actif en prenant la valeur VCC.

A l'instant θ5, le signal SELECT passe à "0" et le potentiel VG redevient nul. De plus, le signal SENSE passe à "0", les transistors T9, T10 se bloquent, le courant ICELL disparaît, et le signal VOUT redevient inactif.

En résumé, lorsque la m-ième impulsion EVENT est fournie par le circuit de détection à l'instant θ0, une m-ième étape de programmation du transistor T1 est réalisée entre θ2 et θ3, puis une mesure du niveau de programmation de T1 est effectuée entre θ4 et θ5. Le niveau de programmation mesuré est comparé au niveau de référence. Le niveau de référence étant atteint (le nombre N est atteint), le potentiel VOUT devient actif pour indiquer que le niveau de référence est atteint ou dépassé, puis redevient inactif à l'instant θ6.

Les figures 1 à 5 montrent un mode préféré de réalisation mais nullement limitatif de l'invention. Des modifications peuvent être apportées aux éléments du circuit de détection d'utilisation 100, sans sortir du cadre de l'invention.

Le circuit 120 de mesure est utilisé seulement pour lire le contenu du circuit de mémorisation 116. Le circuit 120 n'est pas indispensable et peut être supprimé. C'est notamment le cas si le circuit de mémorisation est apte à déclencher une alarme prise en compte par un autre élément du circuit intégré ou bien s'il est apte à déclencher une interruption gérée par une unité d'interruption du circuit intégré.

Dans l'exemple ci-dessus, la durée des signaux SENSE, SELECT, SWITCH notamment, a été choisie pour être égale à un ou deux cycles du signal d'horloge : la durée de ces signaux est fixée par la durée des retards introduits par les bascules 151 à 154 du circuit 130. Cependant, ces signaux peuvent avoir des durées différentes, l'essentiel étant que ces signaux aient une durée suffisante pour réaliser une étape de programmation partielle, ou une étape de mesure selon le cas, dans de bonnes conditions. De préférence cependant, le signal SWITCH est produit avant le signal SENSE, de sorte que l'étape de programmation soit effectuée avant l'étape de mesure.

La fréquence de réalisation des étapes de mesure peut être modifiée également : on peut ne pas effectuer systématiquement l'étape de mesure après chaque étape de programmation partielle, mais effectuer uniquement une étape de mesure lors de vérifications ponctuelles du nombre d'utilisations, comme on l'a vu précédemment.

Le circuit 116 de mémorisation peut également être modifié : De même, on peut ne pas utiliser une seule cellule de mémorisation mais plusieurs utilisées successivement au fur et à mesure des programmations partielles. Ceci permet, pour un même nombre d'utilisations comptabilisées, de réduire le nombre de programmations partielles par cellule de mémorisation et de diminuer ainsi les contraintes de dimensionnement de ces cellules. On peut également envisager de rendre paramétrable le nombre d'utilisations admises en autorisant l'utilisation d'un nombre plus ou moins important de ces cellules.

Bien qu'on ait, dans l'exemple, décrit l'utilisation d'une cellule de type EEPROM, on pourra bien entendu utiliser des cellules d'un autre type, telles que des cellules de type FLASH, et plus généralement tout autre circuit de mémorisation électriquement programmable dont on pourra modifier le niveau de programmation plusieurs fois par le biais de programmations partielles et permettant de stocker le nombre comptabilisé de manière non volatile.

Des modifications peuvent également être apportées au circuit 110 de programmation de la figure 3.

Le circuit 100 de la figure 2 utilise un unique potentiel de programmation VPP. La valeur de ce potentiel fixe la quantité de charges qui est stockée dans la cellule 116 lors de la réalisation d'une étape de programmation de durée donnée.

On peut également utiliser plusieurs potentiels VPP1, VPP2 de programmation, de préférence différents, pour réaliser des étapes de programmation partielle différentes. Ceci peut être intéressant notamment lorsque le circuit intégré utilise plusieurs éléments de sensibilité différente, que l'on souhaite surveiller en utilisant un unique circuit de mémorisation. Les circuit 110 est bien sûr à modifier en conséquence.

Par ailleurs, les transistors T2, T3 du circuit 110 ont pour rôle d'inverser le signal SELECT, ils peuvent être remplacés par tout autre circuit capable d'inverser des signaux logiques. De la même façon, les transistors T6, T7 peuvent être remplacés par un inverseur haute tension, qui fournit un potentiel élevé si un signal logique nul est appliqué sur son entrée, et qui fournit un potentiel nul si un signal logique égal à "1" est appliqué sur son entrée.

Le transistor T4 est un transistor d'isolement qui empêche le potentiel VPP de remonter jusqu'aux drains des transistors T2, T3, dans l'éventualité où le potentiel VPP apparaîtrait sur les grilles des transistors T6, T7. Le transistor T4 peut éventuellement être supprimé. Dans ce cas, le drain de T5 et les grilles de T6, T7 seront connectés ensemble aux drains des transistors T2, T3.

Le transistor T5 est un élément de sécurité qui est utilisé pour verrouiller à "0V" le potentiel VG lorsque le signal SELECT est nul. Le transistor T5 peut éventuellement être supprimé.

De manière générale, le circuit 110 est un circuit qui fournit un potentiel de sortie VG qui prend au moins trois valeurs en fonction de deux (ou plus) signaux de sélection SELECT, SWITCH, il peut être remplacé par tout circuit remplissant cette fonction.

Des modifications peuvent également être apportées au circuit 120. Par exemple, les transistors T11, T12 et les inverseurs I1, 12 sont utilisés pour limiter le potentiel sur le drain des transistors T1, T8; ces éléments peuvent être supprimés si les transistors de mémorisation T1, T8 sont dimensionnés pour supporter des potentiels un peu plus élevés.

Le circuit 130 de la figure 4 n'est qu'un exemple de circuit fournissant les signaux SELECT, SWITCH, SENSE, d'autres circuits de commande peuvent être utilisés, comportant notamment des ensembles de portes et/ou de bascules différents de celui proposé à titre d'exemple. De plus, les bascules D, qui sont utilisées comme circuit de retard, peuvent être remplacées par tout autre circuit ayant une fonction similaire. L'essentiel est, pour mettre en oeuvre l'invention, de disposer d'un circuit de commande qui fournit des signaux SELECT, SWITCH et SENSE ayant les caractéristiques nécessaires au fonctionnement correct des circuits 110, 120, c'est-à-dire des signaux permettant de réaliser une étape de programmation partielle du circuit de mémorisation T1, et éventuellement une étape de mesure du niveau de programmation du circuit 116 et une comparaison de ce niveau avec un niveau de référence.

Le circuit de la figure 2 peut également être amélioré en ajoutant un circuit 160 de sortie pour mémoriser l'activation du signal VOUT. Un tel circuit 160 est représenté en pointillés sur la figure 2; il comprend une borne 161 d'entrée connectée à la borne 125 du circuit 120, une borne 162 d'entrée connectée à une borne 136 du circuit 130 pour recevoir un signal WRITE d'écriture et une borne 163 d'entrée pour recevoir un signal ENABLE de commande d'un utilisateur du circuit.

Le circuit 160 mémorise la valeur du signal VOUT, actif ou inactif, chaque fois qu'il reçoit le signal WRITE actif, et il fournit à l'extérieur la valeur du signal VOUT précédemment mémorisée chaque fois qu'il reçoit un signal ENABLE actif.

Le signal WRITE est produit par le circuit 130 de commande, après chaque réalisation d'une étape de programmation partielle, toutes les M étapes de programmation partielle, ou bien de manière aléatoire, selon le mode de réalisation du circuit.

Le signal ENABLE est quant à lui produit par un utilisateur extérieur, lorsqu'il souhaite savoir si un signal d'alerte a déjà été émis ou pas.

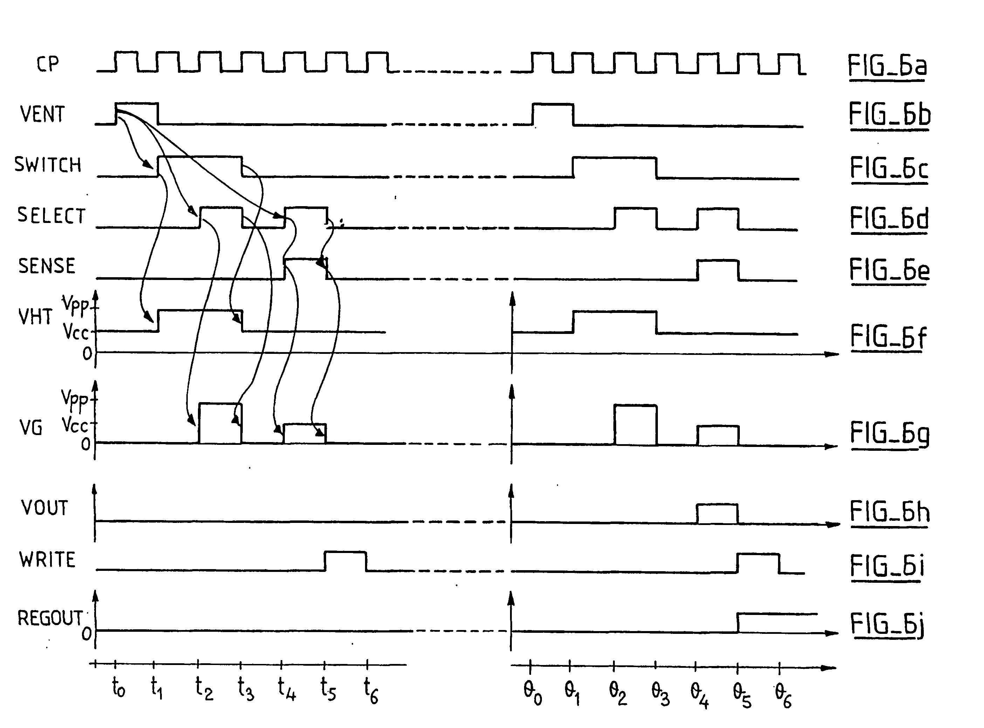

Un exemple de circuit 160 comprend, conformément au schéma de la figure 6, une bascule 165 et une mémoire tampon 166. La bascule 165 comprend une borne d'entrée de donnée et une borne d'entrée d'horloge connectées respectivement aux bornes 161, 162 du circuit 160. La mémoire 166 comprend une borne d'entrée connectée à une borne de sortie de donnée de la bascule 165 pour recevoir un signal REGOUT et une borne d'entrée connectée à la borne 163 pour recevoir le signal ENABLE.

Le signal WRITE est fourni par le circuit 130. Dans l'exemple illustré sur des figures 2 à 6, il est égal au signal SENSE retardé de un cycle du signal d'horloge. Pour cela, on ajoute simplement au circuit 130 une cinquième bascule 159 (représentée en pointillés sur la figure 5) dont une borne d'entrée de donnée est connectée à la borne de sortie de la bascule 154 et dont une borne de sortie est connectée à la borne 136.

Le circuit 160 fonctionne de la manière suivante. Initialement, les signaux WRITE, ENABLE ET REGOUT sont nuls; ils sont représentés sur les figures 7i et 7j. Lors de la n-ième impulsion EVENT, lorsque le signal SENSE passe à "0" à l'instant t6, le signal WRITE passe à "1" et le signal REGOUT reste nul car le signal VOUT est inactif. De la même façon, lors de la m-ième impulsion EVENT, lorsque le signal SENSE passe à "0" à l'instant θ6, le signal WRITE passe à "1", le signal REGOUT passe à "1" et il est maintenu égal à "1".

A tout moment, lorsqu'un signal extérieur ENABLE est reçu, le signal REGOUT est mémorisé dans la mémoire 166 et fourni à l'extérieur.

## Revendications

1. Circuit de détection d'utilisation (100) d'un élément d'un circuit intégré, **caractérisé en ce qu'**il comprend :
- un circuit de mémorisation (116) non volatil électriquement programmable et
- un circuit de programmation (110) pour programmer partiellement ledit circuit de mémorisation en lui fournissant une quantité prédéfinie de charges électriques, et augmenter ainsi progressivement un niveau de programmation, correspondant à une quantité totale de charges électriques stockées dans le circuit de programmation, au fur et à mesure des utilisations de l'élément, de sorte que ce niveau soit représentatif du nombre d'utilisations.

2. Circuit selon la revendication 1, **caractérisé en ce qu'**il comprend un circuit de mesure (120) pour lire le niveau de programmation du circuit de mémorisation et produire un signal d'alerte (VOUT) si ce niveau atteint un niveau de référence représentatif d'un nombre maximum d'utilisations autorisées de l'élément.

3. Circuit selon la revendication 1 ou la revendication 2, **caractérisé en ce que** le circuit de mémorisation (110) comprend au moins une cellule de mémorisation programmable partiellement.

4. Circuit selon la revendication 3, **caractérisé en ce que** la cellule de mémorisation est de type EEPROM, EPROM ou de type FLASH.

5. Circuit selon l'une des revendications 1 à 4, **caractérisé en ce que** le circuit de mémorisation comprend plusieurs cellules de mémorisation utilisées de manière successive au fur et à mesure de l'utilisation de l'élément, une cellule de mémorisation étant utilisée lorsqu'une cellule de mémorisation précédente a atteint un niveau maximum, de sorte que le niveau de programmation de la dernière cellule de mémorisation programmées ajouté au niveau maximum de la ou des cellules précédentes déjà programmées soit représentatif du nombre d'utilisations de l'élément.

6. Circuit selon l'une des revendications 1 à 4, **caractérisé en ce que** le circuit de mémorisation comprend plusieurs cellules de mémorisation, chaque cellule de mémorisation étant utilisée pour mémoriser le nombre d'utilisations d'un élément du circuit intégré associé à ladite cellule de mémorisation, de sorte que le niveau de programmation de chaque cellule de mémorisation soit représentatif du nombre d'utilisations de l'élément qui lui est associé.

7. Circuit selon l'une des revendications 1 à 6, **caractérisé en qu'**il comprend également un circuit de sortie (160) pour mémoriser le signal d'alerte (VOUT).

8. Circuit selon l'une des revendications 1 à 7, **caractérisé en ce qu'**il comprend également un circuit de commande (130), pour piloter le fonctionnement du circuit de programmation, du circuit de mémorisation (116) et éventuellement du circuit de mesure (120) et/ou du circuit de sortie (160), en fonction d'un signal d'utilisation (EVENT) reçu, qui est activé à chaque utilisation du ou des éléments.

9. Circuit selon l'une des revendications 1 à 8, **caractérisé en ce que** l'élément dont l'utilisation est détectée est soit un circuit d'identification ou un circuit de calcul cryptographique du circuit intégré ou une partie de l'un de ces circuits, soit une instruction, une suite particulière d'instructions ou une étape d'un procédé mise en oeuvre par le circuit intégré.

10. Procédé de détection d'utilisation d'un élément d'un circuit intégré, **caractérisé en ce qu'**il comprend une étape de programmation partielle d'un circuit de mémorisation (116) non volatil électriquement programmable par fourniture d'une quantité prédéfinie de charges électriques, effectuée lorsque l'élément est utilisé, de sorte à augmenter progressivement un niveau de programmation, correspondant à une quantité totale de charges électriques stockées dans le circuit de mémorisation au fur et à mesure des utilisations de l'élément.

11. Procédé selon la revendication 10, **caractérisé en ce que** les étapes de programmation partielle réalisées sont identiques à chaque utilisation de l'élément.

12. Procédé selon la revendication 10, **caractérisé en ce que** des paramètres d'une étape de programmation partielle varient selon le nombre d'utilisations déjà réalisées de l'élément.

13. Procédé selon l'une des revendications 10 à 12, **caractérisé en ce qu'**il est utilisé dans un circuit intégré comprenant au moins deux éléments, et **en ce que** des étapes de programmation partielle d'une unique cellule du circuit de mémorisation (116) sont effectuées à chaque utilisation de l'un des éléments, les paramètres d'une étape de programmation pouvant être variables en fonction de l'élément utilisé.

14. Procédé selon l'une des revendications 10 à 12, **caractérisé en ce qu'**il est utilisé dans un circuit intégré comprenant au moins deux éléments, une cellule de mémorisation du circuit de mémorisation (116) étant associée à chaque élément, et **en ce que** des étapes de programmation partielle d'une cellule du circuit de mémorisation (116) sont effectuées à chaque utilisation de l'élément associé, les paramètres d'une étape de programmation pouvant être variables en fonction de l'élément utilisé.

15. Procédé selon l'une des revendications 10 à 14, **caractérisé en ce qu'**il comprend une étape de mesure, pour mesurer le niveau de programmation du circuit de mémorisation (116) et produire un signal d'alerte (VOUT) si ledit niveau de programmation atteint une valeur représentative d'un nombre maximum d'utilisations autorisées de l'élément.

16. Procédé selon l'une des revendications 10 à 15, **caractérisé en ce qu'**il comprend également une étape de mémorisation réalisée après l'étape de mesure, pour mémoriser le signal d'alerte.

17. Carte à puce **caractérisée en ce qu'**elle comprend un circuit de détection d'usure selon l'une des revendications 1 à 9.

## Patentansprüche

1. Schaltkreis zum Erkennen der Verwendung (100) eines Elements von einem integrierten Schaltkreis, **dadurch gekennzeichnet, dass** er umfasst:
einen nicht-volatilen elektrisch programmierbaren Speicherschaltkreis (116) und
einen Programmierungsschaltkreis (110), um den Speicherschaltkreis partiell zu programmieren, indem diesem eine vorgegebene Menge von elektrischen Ladungen zugeführt wird, und um so einen Programmierungspegel zunehmend anzuheben, entsprechend einer Gesamtmenge von elektrischen Ladungen, die in dem Programmierungsschaltkreis gespeichert sind in Abhängigkeit von den Verwendungen des Elements, so dass dieser Pegel die Anzahl der Verwendungen wiedergibt.

2. Schaltkreis nach Anspruch 1, **dadurch gekennzeichnet, dass** er einen Messschaltkreis (120) zum Auslesen des Programmierungspegels des Speicherschaltkreises und zum Erzeugen eines Alarmsignals (VOUT) umfasst, wenn der Pegel einen Referenzpegel erreicht, der eine maximale Anzahl von Verwendungen wiedergibt, die für das Element zulässig sind.

3. Schaltkreis nach Anspruch 1 oder 2, **dadurch gekennzeichnet, dass** der Speicherschaltkreis (110) wenigstens eine partiell programmierbare Speicherzelle umfasst.

4. Schaltkreis nach Anspruch 3, **dadurch gekennzeichnet, dass** die Speicherzelle eine EEPROM-, EPROM- oder eine FLASH-Speicherzelle ist.

5. Schaltkreis nach einem der Ansprüche 1 bis 4, **dadurch gekennzeichnet, dass** der Speicherschaltkreis mehrere Speicherzellen umfasst, die in Abhängigkeit von der Verwendung des Elements nacheinander verwendet werden, wobei eine Speicherzelle verwendet wird, wenn eine vorherige Speicherzelle einen Maximalpegel erreicht hat, so dass der Programmierungspegel der letzten Speicherzelle von denen, die programmiert sind, zusätzlich zu dem Maximalpegel der einen oder mehreren vorangehenden Zellen, die bereits programmiert sind, die Anzahl der Verwendungen des Elements wiedergibt.

6. Schaltkreis nach einem der Ansprüche 1 bis 4, **dadurch gekennzeichnet, dass** der Speicherschaltkreis mehrere Speicherzellen umfasst, wobei jede Speicherzelle verwendet wird, um die Anzahl der Verwendungen eines Elements des integrierten Schaltkreises, das zu der Speicherzelle gehört, abzuspeichern, so dass der Programmierungspegel von jeder Speicherzelle die Anzahl der Verwendungen des Elements wiedergibt, das zu ihr gehört.

7. Schaltkreis nach einem der Ansprüche 1 bis 6, **dadurch gekennzeichnet, dass** er außerdem einen Ausgangsschaltkreis (160) umfasst, um das Alarmsignal (VOUT) abzuspeichern.

8. Schaltkreis nach einem der Ansprüche 1 bis 7, **dadurch gekennzeichnet, dass** er außerdem einen Steuerschaltkreis (130) umfasst, um den Betrieb des Programmierungsschaltkreises, des Speicherschaltkreises (116) und eventuell des Messschaltkreises (120) und/oder des Ausgangsschaltkreises (160) in Abhängigkeit von einem Verwendungssignal (EVENT) zu steuern, das empfangen wurde und das bei jeder Verwendung des einen oder der mehreren Elemente aktiviert wird.

9. Schaltkreis nach einem der Ansprüche 1 bis 8, **dadurch gekennzeichnet, dass** das Element, dessen Verwendung erkannt wurde, entweder ein Identifizierungsschaltkreis oder ein Kryptografieschaltkreis des integrierten Schaltkreises oder ein Teil eines dieser Schaltkreise oder ein Befehl, eine spezielle Folge von Befehlen oder ein Verfahrensschritt, der durch den integrierten Schaltkreis ausgeführt wird, ist.

10. Verfahren zum Erkennen der Verwendung eines Elements eines integrierten Schaltkreises, **dadurch gekennzeichnet, dass** es einen Schritt der partiellen Programmierung eines nicht-volatilen elektrisch programmierbaren Speicherschaltkreises (116) umfasst, indem eine vorgegebene Menge von elektrischen Ladungen zugeführt wird, der jedes Mal ausgeführt wird, wenn das Element verwendet wird, so dass ein Programmierungspegel zunehmend angehoben wird, entsprechend einer Gesamtmenge von elektrischen Ladungen, die in dem Programmierungsschaltkreis gespeichert sind in Abhängigkeit von den Verwendungen des Elements.

11. Verfahren nach Anspruch 10, **dadurch gekennzeichnet, dass** die durchgeführten Schritte der partiellen Programmierung bei jeder Verwendung des Elements identisch sind.

12. Verfahren nach Anspruch 10, **dadurch gekennzeichnet, dass** die Parameter eines Schrittes der partiellen Programmierung in Abhängigkeit von der Anzahl der bei dem Element bereits erfolgten Verwendungen variieren.

13. Verfahren nach einem der Ansprüche 10 bis 12, **dadurch gekennzeichnet, dass** es angewendet wird in einem integrierten Schaltkreis mit wenigstens zwei Elementen und dass die Schritte der partiellen Programmierung einer einzelnen Zelle des Speicherschaltkreises (116) bei jeder Verwendung von einem der Elemente ausgeführt werden, wobei die Parameter eines Schrittes der Programmierung Variablen in Abhängigkeit von dem verwendeten Element sein können.

14. Verfahren nach einem der Ansprüche 10 bis 12, **dadurch gekennzeichnet, dass** es angewendet wird in einem integrierten Schaltkreis mit wenigstens zwei Elementen, wobei eine Speicherzelle des Speicherschaltkreises (116) zu jedem Element gehört, und dass die Schritte der partiellen Programmierung einer Zelle des Speicherschaltkreises (116) bei jeder Verwendung des dazugehörigen Elements durchgeführt werden, wobei die Parameter eines Schrittes der Programmierung Variablen in Abhängigkeit von dem verwendeten Element sein können.

15. Verfahren nach einem der Ansprüche 10 bis 14, **dadurch gekennzeichnet, dass** es einen Schritt der Messung umfasst, um den Programmierungspegel des Speicherschaltkreises (116) zu messen und ein Alarmsignal (VOUT) zu erzeugen, wenn der Programmierungspegel einen Wert erreicht, der eine maximale Anzahl von Verwendungen des Elements wiedergibt, die zulässig sind.

16. Verfahren nach einem der Ansprüche 10 bis 15, **dadurch gekennzeichnet, dass** er außerdem einen Schritt der Speicherung umfasst, der nach dem Schritt der Messung durchgeführt wird, um das Alarmsignal zu speichern.

17. Chipkarte, **dadurch gekennzeichnet, dass** sie einen Schaltkreis zum Erkennen der Verwendung nach einem der Ansprüche 1 bis 9 umfasst.

## Claims

1. Circuit (100) for detecting the use of an integrated-circuit component, **characterised in that** it comprises:
- an electrically programmable non-volatile memory circuit (116), and
- a programming circuit (110) for partially programming the said memory circuit by supplying it with a pre-defined quantity of electrical charges and thus progressively increasing a programming level, corresponding to a total quantity of electrical charges stored in the programming circuit, as the component is used, so that this level represents the number of uses.

2. Circuit according to claim 1, **characterised in that** it comprises a measuring circuit (120) for reading the programming level of the memory circuit and producing an alert signal (VOUT) if this level reaches a reference level representing a maximum number of allowed uses of the component.

3. Circuit according to claim 1 or claim 2, **characterised in that** the memory circuit (110) comprises at least one partially programmable memory cell.

4. Circuit according to claim 3, **characterised in that** the memory cell is of the EEPROM, EPROM or FLASH type.

5. Circuit according to one of claims 1 to 4, **characterised in that** the memory circuit comprises several memory cells used successively as the component is used, a memory cell being used when a previous memory cell has reached a maximum level, so that the programming level of the last memory cell programmed added to the maximum level of the previous cell or cells already programmed represents the number of uses of the component.

6. Circuit according to one of claims 1 to 4, **characterised in that** the memory circuit comprises several memory cells, each memory cell being used for storing the number of uses of a component of the integrated circuit associated with the said memory cell so that the programming level of each memory cell represents the number of uses of the component associated with it.

7. Circuit according to one of claims 1 to 6, **characterised in that** it also comprises an output circuit (160) for storing the alert signal (VOUT).

8. Circuit according to one of claims 1 to 7, **characterised in that** it also comprises a control circuit (130) for controlling the functioning of the programming circuit, the memory circuit (116) and possibly the measuring circuit (120) and/or the output circuit (160), according to a use signal (EVENT) received, which is activated at each use of the component or components.

9. Circuit according to one of claims 1 to 8, **characterised in that** component whose use is detected is either an identification circuit or a cryptographic calculation circuit of the integrated circuit or a part of one of these circuits, or an instruction, a particular series of instructions or a step of a method implemented by the integrated circuit.

10. Method of detecting the use of a component of an integrated circuit, **characterised in that** it comprises a step of partial programming of an electrically programmable non-volatile memory circuit (116) through the supply of a pre-defined quantity of electrical charges, effected when the component is used, so as to progressively increase a programming level, corresponding to a total quantity of electrical charges stored in the memory circuit along with the uses of the component.

11. Method according to claim 10, **characterised in that** the partial programming steps performed are identical at each use of the component.

12. Method according to claim 10, **characterised in that** parameters of a partial programming step vary according to the number of uses already made of the component.

13. Method according to one of claims 10 to 12, **characterised in that** it is used in an integrated circuit comprising at least two elements and **in that** steps of partial programming of a single cell of the memory circuit (116) are performed at each use of one of the components, the parameters of a programming step being able to be variable according to the component used.

14. Method according to one of claims 10 to 12, **characterised in that** it is used in an integrated circuit comprising at least two components, a memory cell of the memory circuit (116) being associated with each component, and **in that** steps of partial programming of a cell of the memory circuit (116) are performed at each use of the associated component, the parameters of a programming step being able to be variable according to the component used.

15. Method according to one of claims 10 to 14, **characterised in that** it comprises a measuring step for measuring the programming level of the memory circuit (116) and producing an alert signal (VOUT) if the said programming level reaches a value representing a maximum number of allowed uses of the component.

16. Method according to one of claims 10 to 15, **characterised in that** it also comprises a storage step performed after the measuring step for storing the alert signal.

17. Chip card, **characterised in that** it comprises a wear detection circuit according to one of claims 1 to 9.
